**Europäisches Patentamt**

**European Patent Office**

**Office européen des brevets**

(19)

(11) Numéro de publication : **0 493 278 A1**

# (12) DEMANDE DE BREVET EUROPEEN

(21) Numéro de dépôt : **91420461.5**

(22) Date de dépôt : **19.12.91**

(51) Int. Cl.$^5$ : **B08B 7/00,** C23C 14/02, C23F 4/00, H01L 21/306

(30) Priorité : **20.12.90 FR 9016385**

(43) Date de publication de la demande : **01.07.92 Bulletin 92/27**

(84) Etats contractants désignés : **DE GB**

(71) Demandeur : **FRANCE TELECOM Etablissement autonome de droit public, 6, Place d'Alleray F-75015 Paris (FR)**

(72) Inventeur : **Dutartre, Didier 1, Chemin du Gamond F-38240 Meylan (FR)** Inventeur : **Bensahel, Daniel 6, Rue Colbert F-38000 Grenoble (FR)** Inventeur : **Regolini, Jorge L. 10, Rue Champs Rochas F-38240 Meylan (FR)**

(74) Mandataire : **Ropital-Bonvarlet, Claude Cabinet Beau de Loménie, 51 Avenue Jean Jaurès, B.P. 7073 F-69341 Lyon Cédex 07 (FR)**

(54) **Procédé pour nettoyer la surface d'un substrat par plasma.**

(57) — Le procédé pour nettoyer, par plasma, la surface d'un substrat (**4**) préalablement à un traitement ultérieur, consiste :

. dans une première phase de nettoyage, à polariser négativement le substrat (**4**) et à soumettre le substrat à un plasma d'argon,

. et, dans une seconde phase de nettoyage, à soumettre le substrat prétraité à un plasma d'hydrogène, de manière à assurer un nettoyage efficace de la surface du substrat.

— Application au nettoyage préalable d'un substrat silicium destiné à recevoir une épitaxie.

EP 0 493 278 A1

La présente invention concerne le domaine technique général des procédés de nettoyage ou de décapage de la surface d'un substrat, de préférence à base de silicium, mis en oeuvre préalablement au traitement ultérieur du substrat, notamment par croissance de couches ou dépôts.

Le traitement, tel qu'une épitaxie d'un substrat à base de silicium, demande que le substrat présente une surface propre, de manière à assurer une épitaxie de qualité. Il apparaît ainsi nécessaire de retirer l'oxyde natif, le carbone et toutes les autres impuretés présentes sur la surface du substrat.

Dans l'application préférée ci-dessus, à savoir l'épitaxie sur silicium, l'état de la technique a proposé d'utiliser, en tant que méthode de nettoyage de la surface d'un substrat, des décapages thermiques réalisés à des températures relativement élevées de l'ordre de 800 à 900° C et résultant de la conversion d'oxyde de silicium en espèce volatile.

Ces méthodes de nettoyage, qui s'effectuent à des températures relativement élevées, ne se trouvent pas adaptées pour réaliser les composants micro-électroniques du type **ULSI** (Ultra Large Scale Integration). En effet, la mise en oeuvre d'une puissance thermique élevée ne permet pas de respecter les profils abrupts de dopage des substrats. De plus, la mise en oeuvre de températures élevées est incompatible avec l'exploitation de nouvelles structures micro-électroniques, telles que des hétérostructures ou des hétéroépitaxies.

Pour tenter de remédier à ces inconvénients, l'état de la technique a proposé d'utiliser un bombardement ionique pour réaliser de tels nettoyages à des températures plus basses. A cet effet, le document **B. ANTHONY et al.**, J. Vac. Sci. Technol., B7, p. 621, 1989, a préconisé d'utiliser des plasmas d'hydrogène pour assurer une telle fonction de décapage. Or, il apparaît que la mise en oeuvre d'un tel plasma ne permet pas de retirer facilement l'oxyde natif présent à la surface du silicium. De plus, un plasma d'hydrogène grave beaucoup plus rapidement le silicium que la silice et toute rugosité dans la silice sera transférée, de façon amplifiée, dans le silicium.

Par ailleurs, les documents **T. J. DONAHUE et al.**, J. Appl. Phys. 57, p. 2757, 1985 et **COMFORT et al.**, J. Appl. Phys. 62, p. 3388, 1987 ont, également, proposé l'utilisation des plasmas d'argon qui sont connus pour agir selon le mécanisme de pulvérisation. La mise en oeuvre de plasmas d'argon nécessite l'utilisation d'ions fortement énergétiques qui produisent des défauts dans le silicium, ainsi qu'une implantation d'argon dans le substrat. De ce fait, les plasmas d'argon sont utilisés à suffisamment haute température et sont suivis, généralement, d'un recuit à relativement haute température, vers 800° C, pour éliminer tous les défauts créés par cette technique.

Enfin, le document **TRI-RUNG YEW et al.**, J. Appl. Phys. 68, p. 4681, 1990 a préconisé de soumettre le substrat à un plasma d'argon mélangé à de l'hydrogène, dans des conditions de températures de l'ordre de 700° C.

L'analyse de l'état de la technique conduit donc à constater qu'il apparaît un besoin de disposer d'un procédé de nettoyage à basse température de la surface d'un substrat, destiné à être mis en oeuvre préalablement à un traitement ultérieur, tel qu'une épitaxie ou un dépôt.

L'objet de l'invention vise donc à satisfaire ce besoin en proposant un nouveau procédé pour nettoyer, à basse température, par plasma, la surface d'un substrat pour retirer toutes les impuretés de cette surface, de manière à permettre la réalisation d'un dépôt ultérieur dans des conditions favorables.

Pour atteindre l'objet ci-dessus, le procédé selon l'invention, pour nettoyer par plasma la surface d'un substrat préalablement à un traitement ultérieur, consiste :

– dans une première phase de nettoyage, à polariser négativement le substrat et à soumettre le substrat à un plasma d'argon,

– et, dans une seconde phase de nettoyage, à soumettre le substrat prétraité à un plasma d'hydrogène, de manière à assurer un nettoyage efficace de la surface du substrat.

Selon une caractéristique avantageuse du procédé selon l'invention, les première et seconde phases,de nettoyage sont réalisées sans la mise en oeuvre de moyens de chauffage.

Selon une autre caractéristique avantageuse, le procédé consiste à polariser négativement, pendant la première phase de nettoyage, le substrat dans une plage de tensions comprise entre 20 et 100 volts.

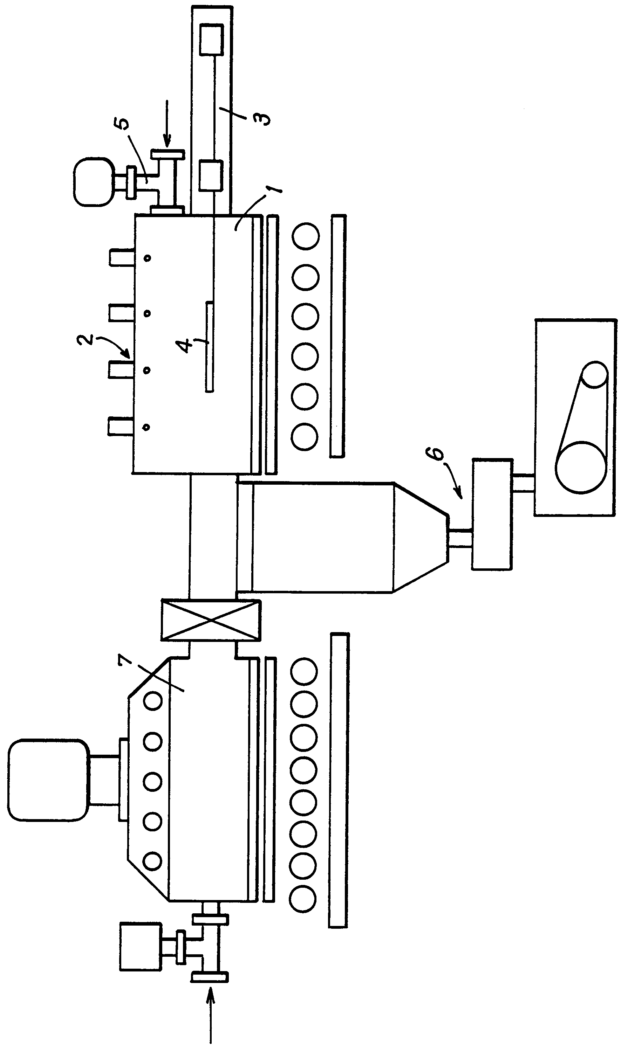

Diverses autres caractéristiques ressortent de la description faite ci-dessous en référence au dessin annexé qui montrent, à titre d'exemple non limitatif, une forme de réalisation de l'objet de l'invention.

**La figure unique** est une vue schématique d'une machine permettant de mettre en oeuvre le procédé de nettoyage conforme à l'invention.

Cette figure illustre un exemple de réalisation d'une machine adaptée pour mettre en oeuvre le procédé selon l'invention de nettoyage de la surface d'un substrat à base, de préférence, de silicium. Cette machine, par exemple du type **JIPELEC, FUV4,** comporte une enceinte étanche **1,** pourvue de moyens **2** adaptés pour produire un plasma micro-ondes multipolaire. De manière classique, il peut être prévu, afin de permettre l'obtention de plasmas d'une bonne homogénéité, de réaliser un confinement magnétique multipolaire et d'utiliser une source micro-ondes localisée.

L'enceinte **1** est équipée, également, d'un dispositif **3** d'amenée, à l'intérieur de l'enceinte **1,** d'un substrat **4,** tel qu'une plaquette de silicium. L'enceinte **1** est également pourvue d'un dispositif d'introduction **5** de gaz et d'un dispositif **6** de pompage de gaz permettant de maintenir la pression du gaz à ioniser à la valeur désirée qui peut être, par exemple, de l'ordre de 10 $^{-1}$ à 10 Pascals.

Conformément à l'invention, le procédé de nettoyage consiste, dans une première phase, à alimenter la chambre en argon et à procéder à l'allumage du plasma, de manière à soumettre le substrat **4** à un plasma d'argon. Pendant cette première phase de nettoyage, il est à noter que le substrat est polarisé négativement par tout moyen connu et adapté, comme, par exemple, une polarisation continue du porte-substrat.

Le plasma d'argon a pour fonction de retirer l'oxyde natif, le carbone, ainsi que toutes les impuretés présentes à la surface du substrat. Cette fonction est assurée par le mécanisme de pulvérisation apparaissant dans un tel plasma d'argon. La polarisation et l'énergie des ions sont choisis pour assumer une telle fonction et peuvent être ajustées en fonction de la préparation de la surface et, notamment, de l'épaisseur de silice présente sur cette surface.

L'expérience a montré que le substrat pouvait être polarisé négativement dans une plage de tensions comprise entre 20 et 100 volts et que l'énergie des ions est, de préférence, comprise entre 20 et 100 électrons-volts. Des expériences pratiques ont montré qu'avec un flux d'ions de l'ordre de 10$^{15}$ ions/cm$^2$ et d'énergie comprise entre 50 et 100 électrons-volts, un traitement à température ambiante, pendant une durée de l'ordre de 2 minutes, était suffisant pour assumer la fonction de nettoyage décrit ci-dessus. Le traitement effectué dans les conditions ci-dessus correspond à l'abrasion de 50 Angströms.

Avantageusement, il est à noter que le traitement par le plasma d'argon peut s'effectuer en s'affranchissant de la mise en oeuvre de moyens de chauffage du substrat. Un tel nettoyage est donc réalisé à des températures de l'ordre, voire inférieures à la température ambiante.

Conformément à l'invention, un tel substrat, prétraité par un plasma d'argon, est soumis à un plasma d'hydrogène lors d'une seconde phase de nettoyage consécutive à la première phase. Dans la machine décrite ci-dessus, il est prévu de substituer, dans la chambre **1,** l'argon par de l'hydrogène. Bien entendu, il peut être prévu de transférer, après la première phase de traitement, le substrat **4** à l'intérieur d'une enceinte distincte, identique à l'enceinte **1,** et dans laquelle est produit le plasma d'hydrogène. Le plasma d'hydrogène, qui est relativement efficace à graver le silicium, permet d'éliminer la zone de silicium du substrat perturbée par le traitement du plasma d'argon. Avantageusement, cette seconde phase est réalisée aussi sans la mise en oeuvre de moyens de chauffage.

Les expériences ont montré qu'un traitement, par plasma d'hydrogène de la surface du substrat pendant une durée de 2 minutes à température ambiante, laisse une surface parfaitement nettoyée. Un tel traitement, par le plasma d'hydrogène, correspond à une gravure de 100 Angströms de silicium monocristallin.

De préférence, le plasma d'hydrogène présente un caractère peu énergétique, de manière à éviter d'induire des défauts dans le silicium. Par exemple, il peut être envisagé que l'énergie des ions s'établisse autour de l'électron-volt.

Selon une caractéristique avantageuse du procédé, il peut être prévu, dans cette seconde phase de nettoyage, de polariser positivement le substrat.

La combinaison des deux phases de nettoyage conduit à un nettoyage efficace et de bonne qualité du substrat. De plus, avantageusement, les deux phases de nettoyage sont effectuées à basse température, c'est-à-dire à des températures inférieures ou de l'ordre de la température ambiante. Le procédé selon l'invention, qui assure un nettoyage à basses températures d'un substrat, autorise la réalisation de composants de microélectronique du type **ULSI**. De plus, le procédé proposé, qui commence par la mise en oeuvre d'une étape peu sélective, est relativement peu dépendant des traitements antérieurs subis par le substrat. Un tel procédé peut donc être largement utilisé dans le domaine d'un substrat à base de silicium.

Le substrat **4** ainsi nettoyé et décapé est particulièrement adapté pour recevoir des dépôts épitaxiques à l'intérieur d'un réacteur **7.** De tels dépôts peuvent, par exemple, être réalisés à une température de l'ordre de 800° C, ce qui constitue une température relativement modérée pour une telle technique.

Le procédé de nettoyage conforme à l'invention permet de décaper une surface d'un substrat à température ambiante ou à une température inférieure, en s'affranchissant des inconvénients connus des techniques précédentes, à savoir, d'une part, une mauvaise efficacité du traitement vis-à-vis de l'oxyde par rapport au silicium, engendrant un transfert des rugosités dans le silicium et, d'autre part, une implantation d'argon s'ancrant dans le réseau silicium.

L'invention n'est pas limitée à l'exemple décrit et représenté, car diverses modifications peuvent y être apportées sans sortir de son cadre.

**Revendications**

**1** - Procédé pour nettoyer, par plasma, la surface d'un substrat (**4**), préalablement à un traitement ultérieur,

caractérisé en ce qu'il consiste :
– dans une première phase de nettoyage, à polariser négativement le substrat (**4**) et à soumettre le substrat à un plasma d'argon,
– et, dans une seconde phase de nettoyage, à soumettre le substrat prétraité à un plasma d'hydrogène, de manière à assurer un nettoyage efficace de la surface du substrat.

**2** - Procédé selon la revendication 1, caractérisé en ce qu'il consiste à réaliser les première et seconde phases de nettoyage, sans la mise en oeuvre de moyens de chauffage.

**3** - Procédé selon la revendication 1, caractérisé en ce qu'il consiste, pour la première phase de nettoyage, à polariser négativement le substrat dans une plage de tensions comprise entre 20 et 100 volts.

**4** - Procédé selon la revendication 1, caractérisé en ce qu'il consiste à soumettre le substrat à un plasma d'argon dont l'énergie des ions est comprise entre 20 et 100 électrons-volts.

**5** - Procédé selon la revendication 1, caractérisé en ce qu'il consiste à soumettre le substrat à un plasma d'hydrogène dont l'énergie des ions s'établit autour de l'électron-volt.

**6** - Procédé selon la revendication 1, caractérisé en ce qu'il consiste, dans la seconde phase de nettoyage, à polariser positivement le substrat.

**7** - Procédé selon la revendication 1, caractérisé en ce qu'il consiste à procéder à la première et à la seconde phases de nettoyage dans deux chambres différentes.

EP 0 493 278 A1

Office européen
des brevets

**RAPPORT DE RECHERCHE EUROPEENNE**

Numero de la demande

EP    91 42 0461

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | GB-A-2 148 171 (M.F. COLLINS ET AL)<br>* abrégé; figure 1 *<br>--- | 1 | B08B7/00<br>C23C14/02<br>C23F4/00<br>H01L21/306 |
| D,A | JOURNAL OF APPLIED PHYSICS.<br>vol. 68, no. 9, 15 Novembre 1990, NEW YORK US<br>pages 4681 - 4693;<br>T.-R. YEW ET AL: 'Low-temperature in situ surface cleaning of oxide-patterned wafers by Ar/H2 plasma sputter'<br>* page 4681, ligne 43 - ligne 59 *<br>--- | 1 | |
| A | JOURNAL OF APPLIED PHYSICS.<br>vol. 62, no. 10, 15 Novembre 1987, NEW YORK US<br>pages 4255 - 4268;<br>W.R. BURGER ET AL: 'An optimized in situ argon sputter cleaning process for device quality low-temperature ( T<= 800 degrees Celsius) epitaxial silicon: Bipolar transistor and pn junction characterization'<br>* abrégé *<br>----- | 4 | |

**DOMAINES TECHNIQUES RECHERCHES (Int. Cl.5)**

B08B
C23C
C23F
H01L

Le présent rapport a été établi pour toutes les revendications

| Lieu de la recherche | Date d'achèvement de la recherche | Examinateur |
|---|---|---|
| LA HAYE | 03 MARS 1992 | FRANKS N.M. |